# EUROPÄISCHE PATENTSCHRIFT

(11) **EP 1 849 189 B1**
(45) Veröffentlichungstag und Bekanntmachung des Hinweises auf die Patenterteilung: **05.09.2012**
(21) Anmeldenummer: 06701624.6
(22) Anmeldetag: 24.01.2006
(51) Int. Cl.: H01L 31/042, H01L 27/142, H01L 31/02

(54) **SCHUTZSCHALTUNG MIT STROM-BYPASS FÜR EIN SOLARZELLENMODUL**
PROTECTIVE CIRCUIT WITH CURRENT BYPASS FOR SOLAR CELL MODULE
CIRCUIT DE PROTECTION A DERIVATION DE COURANT DESTINE A UN MODULE DE CELLULES SOLAIRES

(30) Priorität: 26.01.2005 DE 102005003720; 15.03.2005 DE 102005012213; 20.04.2005 DE 102005018463
(43) Veröffentlichungstag der Anmeldung: 31.10.2007
(73) Patentinhaber: Günther Spelsberg GmbH & Co. KG, 58579 Schalksmühle (DE); Insta Elektro GmbH, 58509 Lüdenscheid (DE)
(72) Erfinder: QUARDT, Dirk, 58638 Iserlohn (DE); GROSCH, Volker, 45549 Herzkamp (DE); GROSSEN, Thomas, 58239 Schwerte (DE); MUNDINGER, Harald, 58849 Herscheid (DE)
(74) Vertreter: Michalski Hüttermann & Partner
(86) Internationale Anmeldenummer: PCT/EP2006/000599
(87) Internationale Veröffentlichungsnummer: WO 2006/079503

(56) Entgegenhaltungen:
- WO-A-03/098703
- DE-C1- 19 904 561
- US-B1- 6 225 793
- PATENT ABSTRACTS OF JAPAN Bd. 1996, Nr. 11, 29. November 1996 (1996-11-29) -& JP 08 172209 A (NEC CORP), 2. Juli 1996 (1996-07-02)

## Beschreibung

Die Ereindung betrifft eine Schutzschaltung gemäß dem Oberbegriff des Patentansprüche 1 oder 3.

Solche Schutzschaltungen zum elektrischen Anschluß an Solarzellen eines Solarzellenmoduls sind aus der WO 03/098 703 A2 sowie aus der der Praxis in vielfältiger Ausgestaltung gut bekannt. Solche Schaltungen werden teilweise auch als Anschlußschaltungen für Solarzellen bezeichnet

Im allgemeinen werden mehrere Solarzellen zu Solarzellenmodulen zusammengeschaltet. Dazu besteht entweder die Möglichkeit der Reihenschaltung oder die Möglichkeit der Parallelschaltung der Solarzellen im Solarzellenmodul. Durch ein Parallelschalten der Solarzellen addieren sich die einzelnen Ströme der Solarzellen zu einem Gesamtstrom. Dabei sollten die parallel geschalteten Solarzellen allerdings im wesentlichen die gleichen physikalischen Eigenschaften aufweisen, so daß sich in der Praxis das Parallelschalten von Solarzellen kaum durchgesetzt hat, insbesondere auch da eine einzelne Solarzelle bereits einen Strom von einigen Ampere liefern kann und die Ausgangsspannung einzelner Solarzellen typischerweise zu gering ist, um elektrische Geräte, wie Haushaltsgeräte, betreiben zu können.

Bei der Zusammenstellung on Solarzellenmodulen aus einzelnen Solarzellen werden diese daher häufig Reihe geschaltet. Ein Problem kann sich dabei jedoch dann ergeben, wenn ein Solarzellenmodul im Betrieb partiell abgeschattet wird, also eine Solarzelle oder eine Mehrzahl von Solarzellen des Solarzellenmoduls weniger oder gar keine Sonnenbestrahlung erhält. Der Grund für eine derartig verringerte Sonnenbestrahlung kann z. B. in einer Verschmutzung der Solarzellen und/oder in Schattenwürfen von Bäumen, Gebäudeeinrichtungen oder Gebäuden selbst liegen.

Im Gegensatz zu einer Abschaltung des Solarzellenmoduls gleichmäßig über seine gesamte Fläche, die nur zur einer Leistungsverringerung insgesamt führt, ergibt sich bei einer partiellen Abschattung folgendes Problem: Durch die in Reihe geschalteten Solarzellen des Solarzellenmoduls fließt ein gemeinsamer Strom, wobei jede einzelne Solarzelle mit ihrer jeweiligen Spannung zur Gesamtspannung des Solarzellenmoduls beiträgt. Wird nun eine Solarzelle abgeschattet, so erzeugt diese keine Spannung mehr und setzt dem Stromfluß im Solarzellenmodul praktisch eine Diode in Sperrichtung entgegen. Dies bedeutet jedoch, daß das gesamte Solarzellenmodul keinen Strom mehr liefern kann, so daß die gesamte Funktion des Solarzellenmoduls beeinträchtigt ist.

Weiterhin gilt, daß an der abgeschatteten Solarzelle eine Spannung anliegt, die abhängig ist von der Position der abgeschatteten Solarzelle in der Reihenschaltung. Ist diese an der abgeschatteten Solarzelle anliegende Spannung größer als ihre Sperrspannung, so wird es in der Solarzelle zu einem Durchschlag und damit zu einer dauerhaften Beschädigung kommen.

Selbst wenn es zu keiner Beschädigung der Solarzelle durch einen Durchschlag kommen sollte, wird in einer abgeschatteten Solarzelle eine große Verlustleistung umgesetzt, so daß sich die abgeschattete Solarzelle aufheizt. Auch eine solche Aufheizung kann zu Beschädigungen an der abgeschatteten Solarzelle sowie an den ihr benachbarten Solarzellen führen.

Um die mit teilweise abgeschatteten Solarzellen verbundene Problematik vermeiden, werden Schutzeinrichtungen verwendet, im allgemeinen nämlich Bypass-Dioden, die antiparallel zu den Solarzellen geschaltet werden. Auf diese Weise wird erreicht, daß eine abgeschattete Solarzelle zwar keinen Anteil mehr zur Gesamtspannung des Solarzellenmoduls leistet, der Stromfluß jedoch trotzdem erhalten bleibt. Das Solarzellenmodul zeigt somit lediglich eine verminderte Betriebsspannung, fällt jedoch nicht vollständig aus. Außerdem wird in der abgeschatteten Solarzelle keine Leistung mehr umgesetzt, so daß eine Beschädigung der abgeschatteten Solarzelle vermieden werden kann.

Grundsätzlich könnte jeder Solarzelle eines Solarzellenmoduls genau eine Bypass-Diode zugeordnet sein. Häufig jedoch wird so vorgegangen, daß eine Mehrzahl hintereinander geschalteter Solarzellen, also ein sogenannter String von Solarzellen, jeweils durch eine gemeinsame Bypass-Diode abgesichert wird.

Schutzschaltungen zum elektrischen Anschluß an Solarzellen eines Solarzellenmoduls weisen somit im allgemeinen wenigstens eine Bypass-Diode, häufig eine Mehrzahl von Bypass-Dioden auf. Damit ist jedoch das Problem verbunden, daß die zum elektrischen Anschluß von Solarzellen eines Solarzellenmoduls verwendeten Schutzschaltungen durch die in den Bypass-Dioden umgesetzte Leistung stark erwärmt werden, was unter verschiedenen Aspekten nachteilig ist.

In der WO 03/098703 A2 ist eine Schaltungsanordnung zur Steuer-bzw. Regelung von Photovoltaikanlagen beschrieben, die eine Vielzahl seriell oder/und parallel verschalteter Solargeneratoren umfassen. Um Leistungsverluste der Solargeneratoren zu vermeiden, welche darin begründet liegen, dass nicht alle Solargeneratoren in ihrem Leistungsmaximum betrieben werden, ist jedem Solargenerator ein variabler Energie-Bypass zugeordnet, der derart gesteuert, bzw. geregelt wird, dass jeder Solargenerator kontinuierlich in seinem jeweils aktuellen, spezifischen Leistungsmaximum betrieben wird.

Weiterhin ist aus der DE 199 04 561 Cl eine Maximum-Power-Point-Steuerung von Solargeneratoren bekannt, bei der ein vom Solargenerator elektrisch isolierter Sensor eingesetzt wird. Dabei wird quasi kontinuierlich die Stromkernlinie des Sensors bestimmt, aus der Stromkernlinie die Leistungskernlinie berechnet und aus deren Maximum quasi kontinuierlich die Regelgröße für den Wandler abgeleitet. Der Sensor ist ein Solarmodul des Typs und der Charge, wie die den Solargenerator bildenden Solarmodule.

Schließlich ist in der US 6,225,793 B1 eine Schaltungsanordnung zur Stromerzeugung mit Solarzellen beschrieben, wobei die Solarzellen in Ketten von jeweils mehreren Zellen in Reihe geschaltet sind. Zu jeder Kette ist eine Bypass-Diode parallel geschaltet, und zu zwei und/oder mehr Bypass-Dioden von in Serie angeordneten Ketten sind weitere Dioden parallel gelegt. Mit dieser Anordnung soll die Zahl der stromführenden Dioden bei Abschaltung beliebiger Ketten reduziert werden.

Es ist die Aufgabe der Erfindung, eine derartige Schutzschaltung zum elektrischen Anschluß an Solarzellen eines Solarzellenmoduls anzugeben, die sich im Betrieb nur gering erwärmt.

Die zuvor genannte Aufgabe ist dadurch die begenstät de der webhängigen Ansprüche gelöst.

Erfindungsgemäß ist also vorgesehen, daß zur Vermeidung der oben beschriebenen, mit teilweise abgeschatteten Solarzellen verbundenen Problematik als Schutzeinrichtung eine gesteuerte elektronische Schaltanordnung verwendet wird, so daß die Verwendung von Bypass-Dioden reduziert oder ganz vermieden werden kann. Durch den Ersatz von Bypass-Dioden durch eine gesteuerte elektronische Schaltanordnung, die zu den Bypass-Dioden funktional im wesentlichen gleichwirkend ist, kann eine Verringerung der Erwärmung der Schaltanordnung erzielt werden, wie nachfolgend ausgeführt.

Diese funktionale Gleichwirkung zu den aus dem Stand der Technik bekannten Bypass-Dioden kann nun auf unterschiedliche Arten und Weisen erzielt werden. Erfindungs gemäß ist dazu vorgesehen, daß die gesteuerte elektronische Schaltanordnung eine Ansteuerschalung und eine von der Ansteuerschaltung ansteuerbare Schalteinrichtung aufweist, wobei die Schalteinrichtung parallel zu wenigstens einer Solarzelle, vorzugsweise parallel zu einem String von Solarzellen, geschaltet ist und im Falle einer Abschattung einer der Solarzellen, zu der sie parallel geschaltet ist, von der Ansteuerschaltung wenigstens zeitweise aufgesteuert wird, so daß ein Strom-Bypass für die abgeschattete Solarzelle erzielt wird.

Entsprechende Schalteinrichtungen lassen sich auf verschiedene Arten realisieren. Gemäß einer Ansgestaltung der Erfindung ist jedoch vorgesehen, daß die Schalteinrichtung zwei in Reihe geschaltete und von der Ansteuerschaltung angesteuerte elektrische oder elektronische Schaltelemente aufweist. Erfindungs gemäß ist dabei vorgesehen, daß als Schaltelemente zwei gegeneinander gepolte Transistoren, vorzugsweise zwei MOSFETs, vorgesehen sind. Weiterhin gilt, daß gemäß einer bevorzugten Weiterbildung der Erfindung vorgesehen ist, daß die Stromversorgung der Ansteuerschaltung über den von den nicht abgeschatteten Solarzellen des Solarzellenmoduls erzeugten Strom erfolgt, wobei gemäß einer bevorzugten Weiterbildung der Erfindung insbesondere vorgesehen ist, daß die Ansteuerschaltung mit einem Speicherkondensator versehen ist.

Gemäß der Erfindung ist alternativ vorgesehen, daß als Schutzeinrichtung eine gesteuerte elektronische Schaltungsanordnung vorgesehen ist, die für wenigstens einen String von Solarzellen wenigstens einen Transistor und wenigstens einen parallel dazu geschalteten DC/DC-Wandler aufweist, welcher über einen Energiespeicher mit einer Ansteuerschaltung in Verbindung steht Bei einer solchen Ausbildung ist besonders vorteilhaft, daß die Schutzeinrichtung wenige preisgünstige MOSFETs mit geringem Platzbedarf aufweist, weil mit Hilfe eines Spannungswandlers bereits aus der geringen Flußspannung der parasitären Diode des MOSFET die Spannung erzeugt wird, die zu dessen Ansteuerung erforderlich ist.

Weiterhin ist besonders vorteilhaft, wenn die Spannungswandlung durch die Integration einer Schutzeinrichtung in wenigstens zwei Strings von Solarzellen eines Solarzellenmodnls erfolgt. Einerseits ist es so möglich, daß sich die Schutzeinrichtung wechselweise aus der Spannung, die über einem MOSFET ansteht, ausreichend versorgt wird, weil mehrere MOSFETs vorhanden sind. Andererseits kann bei Abschattung aller zu einem String gehörenden Solarzellen aus der Summe der Flußspannungen der parasitären Dioden der MOSFETs eine ausreichende Spannung gewonnen werden, um diese zur Wandlung und Ansteuerung der MOSFETs zu verwenden. Zudem ist es vorteilhaft, daß die maximale, in Rückwärtsrichtung auftretende Spannung je Schutzeinrichtung auf die Flußspannung einer Siliziumdiode begrenzt ist, was das Risiko des kompletten Ausfalls der Versorgung bei unzureichender Beleuchtung der in Betrieb verbliebenen Solarzellen z. B. bei diffusem Licht minimiert.

Schließlich ist bei allen zuvor genannten Ausgestaltung von Schutzschaltungen für Solarzellen eines Solarzellenmoduls gemäß eines Beipiels, das nicht Teil der beanspruchten Erfindung ist. vorgesehen, daß ein Überspannungsschutzelement zum Schutz der Schutzschaltung sowie der Solarzellen vor Überspannungen, z.B. durch einen benachbarten Blitzeinschlag, verwendet wird.

Im einzelnen gibt es nun eine Vielzahl von Möglichkeiten, die erfindungsgemäßen Schutzschaltungen auszugestalten und weiterzubilden. Dazu wird auf die Unteransprüche sowie auf die nachfolgende detaillierte Beschreibung eines bevorzugten Ausführungsbeispiels der Erfindung verwiesen. In der Zeichnung zeigt
- Fig. 1: schematisch eine Schutzschaltung gemäß einem ersten bevorzugten Ausführungsbeispiel der Erfindung,
- Fig. 2: den Aufbau der Ansteuerschaltung aus Fig. 1 im einzelnen,
- Fig. 3: schematisch eine Schutzschaltung gemäß einem zweiten bevorzugten Ausführungsbeispiel,
- Fig. 4: schematisch eine Schutzschaltung gemäß einem dritten bevorzugten Ausführungsbeispiel,
- Fig. 5: den Aufbau eines DC/DC-Wandlers aus den Fig. 3 bzw. 4 im einzelnen und
- Fig. 6: den Aufbau einer Ansteuerschaltung aus den Fig. 3 bzw. 4 im einzelnen.

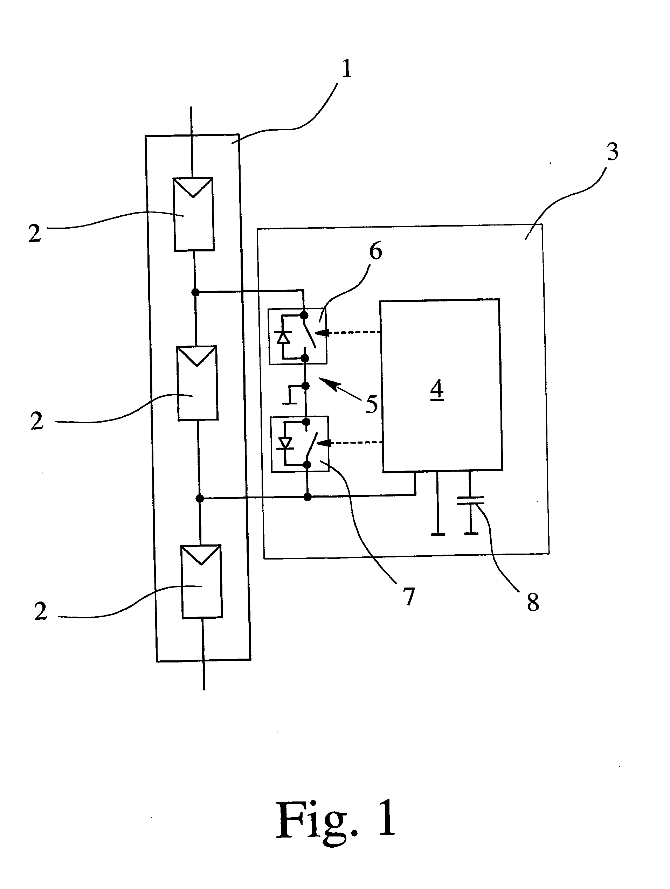

Fig. 1 zeigt eine Solarzelle 1, die eine Mehrzahl von in Reihe geschalteten Strings 2 aufweist, die ihrerseits aus mehreren, im einzelnen nicht mehr dargestellten, ebenfalls in Reihe geschalteten Solarzellen bestehen. Das Vorsehen von drei Strings 2 für das Solarzellenmodul 1 ist rein exemplarisch. Ebenso exemplarisch ist für lediglich einen String 2 die Absicherung über eine Schutzschaltung gemäß einem bevorzugten Ausführungsbeispiel der Erfindung gezeigt. Eine entsprechende Absicherung kann natürlich für jeden String vorgesehen sein.

Wie zuvor schon ausgeführt, ist es das Ziel, eine derartige Schutzschaltung anzugeben, die gewährleistet, daß im Falle einer Abschattung des damit abgesicherten Strings ein Strom-Bypass für diesen abgeschatteten String erzielt wird, so daß das Solarzellenmodul 1 einerseits weiterhin einsatzbereit bleibt, also einen Strom liefert, und andererseits eine Beschädigung des abgeschatteten Strings 2 verhindert wird. Dazu weist die Schutzschaltung eine gesteuerte elektronische Schaltanordnung 3 auf, die über eine Ansteuerschaltung 4 sowie eine Schalteinrichtung 5 verfügt.

Die Schalteinrichtung 5 wird von zwei Schaltelementen gebildet, nämlich von zwei gegeneinander gepolten MOSFETs 6, 7, die von der Ansteuerschaltung 4 ansteuerbar sind. Im übrigen ist für die Ansteuerschaltung 4 ein Speicherkondensator 8 vorgesehen, so daß im Falle einer Abschattung des durch die Schutzschaltung abgesicherten Strings 2 folgender Ablauf ermöglicht wird:

Bei Abschattung des abgesicherten Strings 2 und weiterer Beleuchtung der verbleibenden Strings 2 des Solarzellenmoduls 1 baut sich über den unteren, sperrend wirkenden MOSFET 7 aufgrund der parasitären Diode des oberen MOSFETs 6 eine Spannung auf. Die Ansteuerschaltung 4 ist nun derart ausgelegt, daß sie diese Spannung durch teilweises Aufsteuern wenigstens des MOSFETs 7 auf ca. 20 V begrenzt, so daß eine Beschädigung des abgesicherten Strings 2 vermieden wird. In dieser Phase lädt sich der Speicherkondensator 8 strombegrenzt aus der Spannung über den MOSFET 7 auf. Sobald der Speicherkondensator 8 auf ca. 15 V aufgeladen ist, werden die MOSFETs 6, 7 vollständig aufgesteuert, wodurch die über den MOSFETs 6, 7 anliegende Spannung zusammenbricht. Vom Auftreten der anfänglichen Sperrspannung bis zu diesem Zeitpunkt des Zusammenbrechens der Spannung vergehen nur wenige Mikrosekunden.

Durch den Eigenstromverbrauch der Ansteuerschaltung 4 sinkt die Spannung über dem Speicherkondensator 8 und an den Gates der MOSFETs 6, 7 langsam ab. Sobald eine Spannung unterschritten wird, bei der ein vollständige Aufsteuem der MOSFETs 6, 7 nicht mehr gewährleistet ist, schaltet die Ansteuerschaltung 4 wenigstens den MOSFET 7 ab. Über den MOSFET 7 baut sich dann eine Spannung auf, die wiederum, wie oben beschrieben, begrenzt wird. Die Leitendphase der MOSFETs 6, 7 dauert mehrere zehn Millisekunden. Aufgrund der verglichen zur Leitendphase sehr kurzen spannungsbegrenzten Sperrphase fallen die momentan hohen Verlustleistungen über den MOSFETs 6, 7 während der Sperrphasen damit gegenüber den Leitendverlusten kaum ins Gewicht, so daß insgesamt Verluste deutlich unter denen einer Schottky-Diode erreicht wird.

Die Ansteuerschaltung 4 ist weiterhin derart ausgelegt, daß sie bei Beleuchtung des damit abgesicherten Strings 2 nicht versorgt wird, so daß die MOSFETs 6, 7 sperren. Außer den geringen Sperrströmen der MOSFETs 6, 7 treten somit durch die gesteuerte elektronische Schaltanordnung 3 keinerlei Verluste auf, so daß die Gesamtverluste in der Praxis sogar unter denen von Schottky-Dioden liegen. Darüber hinaus ist bei der vorliegend beschriebenen Schutzschaltung gemäß einem bevorzugten Ausführungsbeispiel der Erfmdung wesentlich, daß sich die gesteuerte elektrische Schaltanordnung in der spannungsbegrenzten Sperrphase aus den verbleibenden, also noch beleuchteten Strings 2 versorgt, so daß keine Fremdversorgung erforderlich ist.

Um die oben genannte Funktionalität zu ermöglichen, weist die Ansteuerschaltung 4 im wesentlichen einen Schmitt-Trigger auf, der vom Drain des MOSFETs 7 versorgt wird. Dieser Schmitt-Trigger sorgt dafür, daß die MOSFETs 6, 7 nur dann aufgesteuert werden, wenn am Kondensator 8 eine Spannung anliegt. Das Puls-Pausen-Verhältnis ergibt sich aus der Hysterese des Schmitt-Triggers und dem Eigenstromverbrauch der Schaltanordnung 3 in Verbindung mit der Kapazität des Kondensators 8.

Die Ansteuerschaltung 4 läßt sich besonders einfach z. B. mit einem Voltage-Supervisor-IC verwirklichen, wie dem MAX6462 von Maxim Integrated Products. Bei Verwendung eines solchen Voltage-Supervisor-IC ist lediglich eine einfache zusätzliche Beschaltung erforderlich, die eine Diode aufweist, die die Schaltung vor der regulären gepolten Betriebsspannung bei beleuchtetem String schützt, und einem Widerstand, der den Strom durch diese Diode begrenzt, solange die MOSFETs noch nicht durchgeschaltet sind. Die Diode in Verbindung mit dem Widerstand am Ausgang der Ansteuerschaltung 4 begrenzt die Spannung über die MOSFETs 6, 7, während sich die Spannung über den Kondensator 8 erst aufbaut.

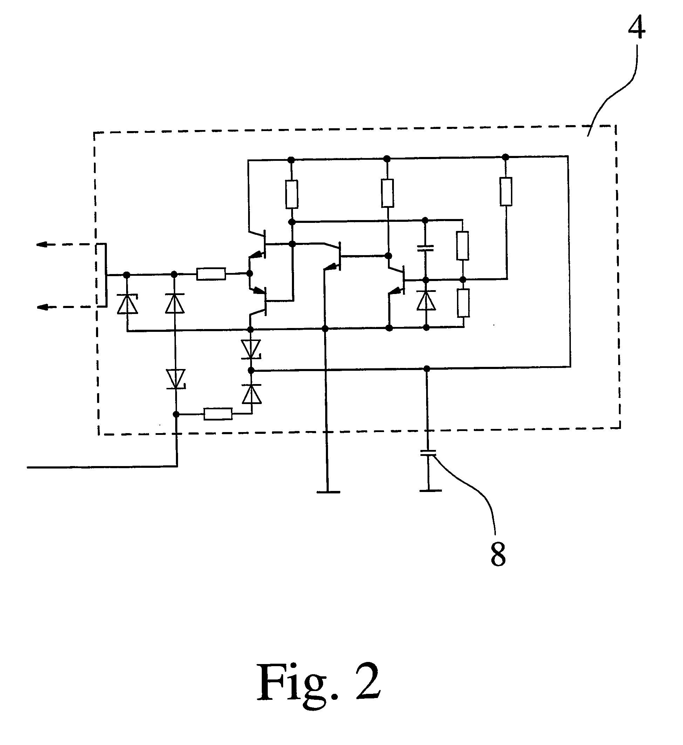

Damit stellt die Ansteuerschaltung 4 insgesamt im wesentlichen eine Komparatorschaltung dar, die im einzelnen auch so aufgebaut sein kann, wie aus Fig. 2 ersichtlich. Diese Schaltung stellt im wesentlichen eine diskrete Nachbildung des zuvor genannten Voltage-Supervisor-ICs mit der ebenfalls oben angesprochenen Zusatzbeschaltung dar.

Im folgenden werden ein zweites und ein drittes bevorzugtes Ausführungsbeispiel der Erfindung beschrieben, die einen bzw. zwei DC/DC-Wandler aufweisen.

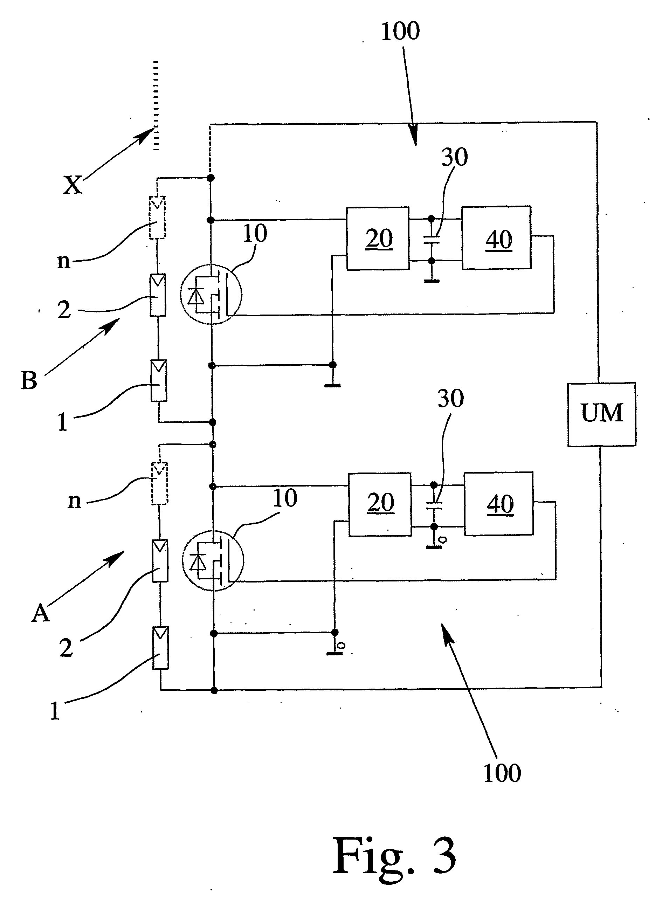

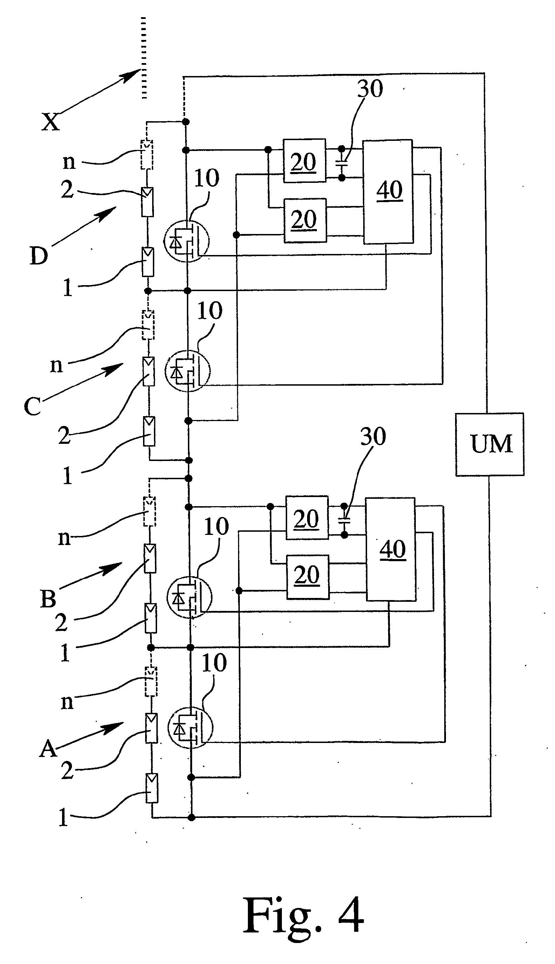

Wie aus den Figuren 3 und 4 hervorgeht, weist ein Solarzellenmodul üblicherweise mehrere in Reihe geschalteten Strings A, B, ..., X auf, denen wenigstens als Schutzeinrichtung eine Schaltanordnung 100 zugeordnet ist. Vorliegend sind nur die Strings A, B explizit dargestellt, während String X nur mit Punkten angedeutet ist und darstellen soll, daß grundsätzlich beliebig viele Strings in Reihe geschaltet sein können. Jeder String A - X besteht aus mehreren in Reihe geschalteten Solarzellen 1 - n.

Wie insbesondere aus Figur 3 hervorgeht, weist gemäß dem zweiten bevorzugten Ausführungsbeispiel der Erfindung die Schaltungsanordnung für jeden String A - X als Schutzeinrichtung ein MOSFET 10 und einen DC/DC-Wandler 20 auf, der über einen Energiespeicher 30 mit einer Ansteuerschaltung 40 in Verbindung steht. Ein MOSFET 10 ist, wie bereits beschrieben, jeweils parallel zu einem String A - X angeordnet und steht über sein Gate mit der Ansteuerschaltung 40 in Verbindung. Alle Strings A - X sind zu einem Solarzellenmodul zusammengefaßt und einem Umrichter UM zugeordnet.

Wie insbesondere aus Figur 4 hervorgeht, sind gemäß dem dritten bevorzugten Ausführungsbeispiel der Erfindung jeweils zwei der Strings A - X, nämlich jeweils die beiden Strings A und B sowie C und D gemeinsam einer Schutzeinrichtung zugeordnet. Jede Solarzellenreihe A und B bzw. C und D weist einen parallel geschalteten MOSFET 10 auf. Über ihr Gate stehen die beiden MOSFETs 10 jeweils mit einer gemeinsamen Ansteuerschaltung 40 in Verbindung, wobei die Versorgung der Ansteuerschaltung 40 durch die beiden je einem String A - X zugeordneten DC/DC-Wandler 20 erfolgt, die der Reihenschaltung der Strings A - X parallel geschaltet sind, wobei einem der DC/DC-Wandler 20 ein Energiespeicher 30 zugeordnet ist. Einerseits ist es so möglich, daß sich die gemeinsame Schutzeinrichtung für zwei der Strings A - X wechselweise aus der Spannung die über einem MOSFET 10 ansteht, ausreichend versorgt wird, weil zwei MOSFETs 10 je Schutzeinrichtung vorhanden sind. Andererseits kann bei Abschattung aller zu einer Schutzeinrichtung gehörenden Strings aus der Summe der Flußspannungen der parasitären Dioden der MOSFETs 10 eine ausreichende Spannung gewonnen werden, um diese zur Wandlung und Ansteuerung der MOSFETs 10 zu verwenden. Alle Strings A - X sind auch hier zu einem Solarzellenmodul zusammengefaßt und einem Umrichter UM zugeordnet.

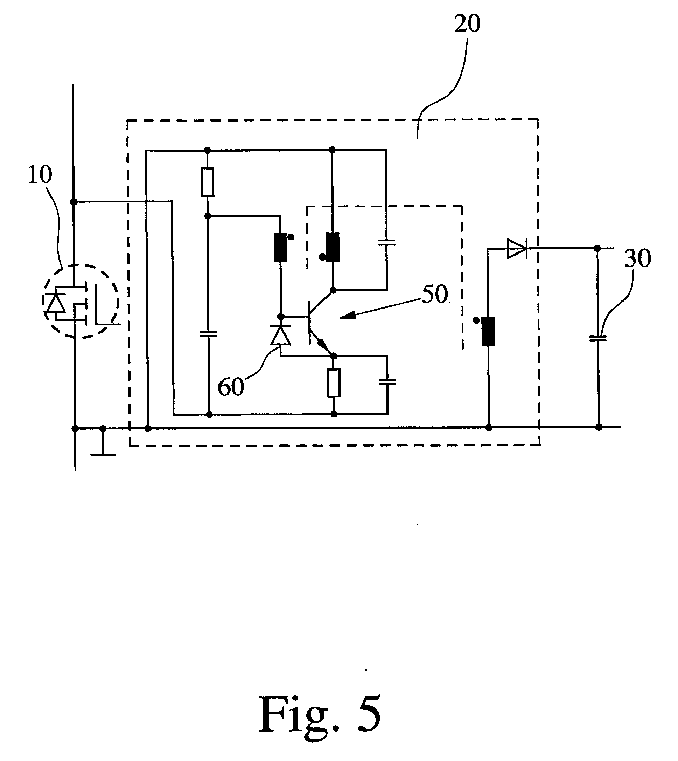

Aus Fig. 5 ist nun ersichtlich, wie der DC/DC-Wandler 20 aus Fig. 3 im einzelnen ausgebildet sein kann. Der DC/DC-Wandler 20, der die bei Abschattung eines Strings A - X über der internen Diode des MOSFETs 10 entstehende Spannung in eine zur Ansteuerung des MOSFETs 10 geeignete Spannung wandelt, soll mit Eingangsspannungen unter 0,7 V arbeiten, um die Bypass-Funktion sicherzustellen. Zu diesem Zweck kann z. B. ein mit einem Germanium-Transistor 50 aufgebauter Meissner-Oszillator dienen, dessen Übertrager eine dritte Wicklung enthält. Bezüglich des Meissner-Oszillators darf verwiesen werden auf das Lehrbuch von U. Tietze und Ch. Schenk "Halbleiter-Schaltungstechnik", 9. Auflage, S. 461 f. Über die dritte Wicklung des Übertragers und eine Einweggleichrichtung kann durch die Wahl des Übersetzungsverhältnisses eine hinreichend große Ansteuerung für den MOSFET 10 abgegriffen werden. Eine antiparallel zur Basis-Emitter-Strecke des Transistors 50 angeordnete Siliziumdiode 60 dient dem Schutz des Transistors 50 gegen die bei beleuchtetem String A - X anstehende inverse Eingangsspannung.

Die Ansteuerschaltung 40 besteht im einfachsten Fall im wesentlichen aus einem Schmitt-Trigger, der bei Überschreiten einer bestimmten Schwellspannung über den Kondensator 30 diese Spannung auf das Gate des MOSFETs 10 legt und bei Unterschreitung dieser Schwellspannung um einen durch die Hysterese gegebenen Wert das Gate entlädt. Der Schmitt-Trigger sorgt dafür, daß der MOSFET 10 nur dann aufgesteuert wird, wenn am Kondensator 30 eine Spannung oberhalb der Schwellspannung der MOSFETs 10 anliegt. Das Puls-Pausenverhältnis ergibt sich aus der Hysterese des Schmitt-Triggers und dem Eigenstromverbrauch der Gesamtschaltung in Verbindung mit der Kapazität des Kondensators 30.

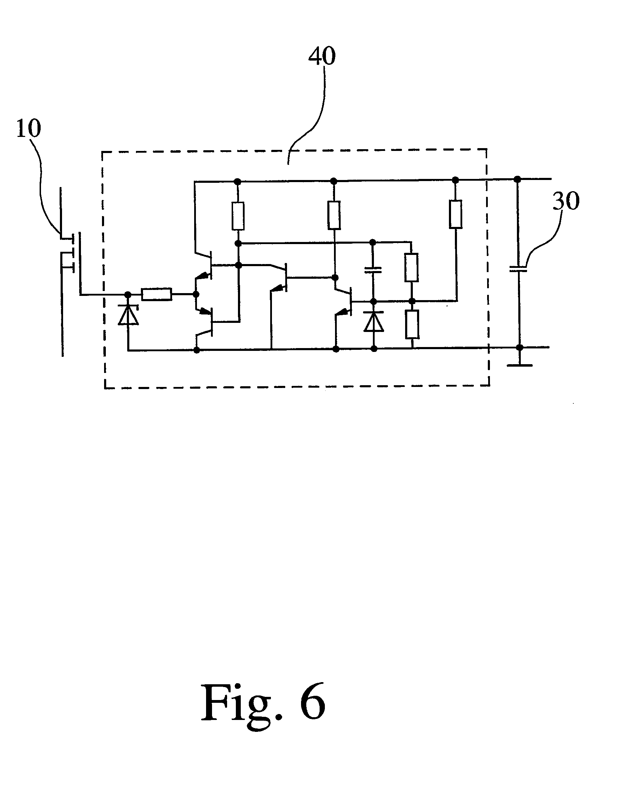

Ähnlich wie die weiter oben beschriebene Ansteuerschaltung 4 aus Fig. 1 läßt sich bei dem vorliegend beschriebenen bevorzugten Ausführungsbeispiel der Erfindung der Schmitt-Trigger besonders einfach mit einem Voltage-Supervisor-IC verwirklichen, wie dem schon angesprochenen MAX6462 von Maxim Integrated Products. Im übrigen gilt vorliegend, wie auch für das zuvor beschriebene bevorzugte Ausführungsbeispiel der Erfindung, daß man geeignete Schmitt-Trigger-Schaltungen insbesondere durch die Verwendung von Logic-Level-MOSFETs erzielt. Aus Fig. 6 ist nun ein Beispiel für eine Ansteuerschaltung 40 im einzelnen ersichtlich, wie sie praktisch einem diskreten Nachbau eines Voltage-Supervisor-ICs entspricht.

Im Ergebnis werden durch die Erfindung damit Schutzschaltungen für Solarzellen eines Solarzellenmoduls bereitgestellt, die genauso unproblematisch einsetzbar sind wie eine Schutzschaltung mit Bypass-Dioden, jedoch wesentlich geringere Verlustleistungen aufweisen, so daß wesentlich höhere Ströme abgesichert werden können.

## Patentansprüche

1. Schutzschaltung, zum elektrischen Anschluss von wenigstens einer Solarzelle eines Solarzellenmoduls (1), mit einer eine gesteuerte elektronische Schaltanordnung (3, 100) aufweisenden Schutzeinrichtung, wobei
die gesteuerte elektronische Schaltanordnung (3, 100) eine Ansteuerschaltung (4, 40) und eine von der Ansteuerschaltung (4, 40) ansteuerbare Schalteinrichtung (5,10) aufweist, die Schalteinrichtung (5, 10) parallel zu wenigstens einer Solarzelle geschaltet ist und im Falle einer Abschattung der Solarzelle von der Ansteuerschaltung (4, 40) wenigstens zeitweise aufgesteuert wird, so dass ein Strom-Bypass für die abgeschattete Solarzelle erzielt wird, **dadurch gekennzeichnet**, daβ die Schutzeinrichtung im Fall der abgeschatteten Solarzelle als zu der abgeschatteten Solarzelle paralleler Strom-Bypass für die abgeschattete Solarzelle wirkt,
die Schalteinrichtung (5) zwei in Reihe geschaltete und von der Ansteuerschaltung (4) angesteuerte elektrische oder elektronische Schaltelemente (6, 7) aufweist, und als Schaltelemente (6, 7) zwei gegeneinander gepolte Transistoren vorgesehen sind.

2. Schutzschaltung nach Anspruch 1, **dadurch gekennzeichnet, dass** die gegeneinander gepolten Transistoren MOSFETs sind.

3. Schutzschaltung, zum elektrischen Anschluss von wenigstens einer Solarzelle eines Solarzellenmoduls (1), mit einer eine gesteuerte elektronische Schaltanordnung (3, 100) aufweisenden Schutzeinrichtung, wobei
die gesteuerte elektronische Schaltanordnung (3, 100) eine Ansteuerschaltung (4, 40) und eine von der Ansteuerschaltung (4, 40) ansteuerbare Schalteinrichtung (5, 10) aufweist und die Schalteinrichtung (5, 10) parallel zu wenigstens einer Solarzelle geschaltet ist und im Falle einer Abschattung der Solarzelle von der Ansteuerschaltung (4, 40) wenigstens zeitweise aufgesteuert wird, so dass ein Strom-Bypass für die abgeschattete Solarzelle erzielt wird, **dadurch gekennzeichnet daß** die Schutzeinrichtung im Fall der abgeschatteten Solarzelle als zu der abgeschatteten Solarzelle paralleler Strom-Bypass für die abgeschattete Solarzelle wirkt, und die Schutzeinrichtung wenigstens einen Transistor (10) und wenigstens einen parallel dazu geschalteten DC/DC- Wandler (20) aufweist, welcher über einen Energiespeicher (30) mit der Ansteuerschaltung (40) in Verbindung steht.

4. Schutzschaltung nach Anspruch 3, **dadurch gekennzeichnet, dass** als Transistor (10) ein MOSFET vorgesehen ist.

5. Schutzschaltung nach Anspruch 3 oder 4, **dadurch gekennzeichnet, dass** mehreren Strings (A - X) von Solarzellen gemeinsam eine Schutzeinrichtung zugeordnet ist, die je String (A - X) einen parallel geschalteten Transistor (10) aufweist, welche über ihr jeweiliges Gate jeweils mit einer Ansteuerschaltung (40) in Verbindung stehen.

6. Schutzschaltung nach Anspruch 5, **dadurch gekennzeichnet, dass** die Versorgung der Ansteuerschaltung (40) je String (A - X) durch einen jeweiligen DC/DC- Wandler (20) erfolgt, wobei die DC/DC- Wandler (20) der Reihenschaltung der Strings (A - X) parallel geschaltet sind.

7. Schutzschaltung nach Anspruch 6, **dadurch gekennzeichnet, dass** wenigstens einem der DC/DC- Wandler (20) ein Energiespeicher (30) zugeordnet ist.

8. Schutzschaltung nach einem der Ansprüche 1 bis 7, **dadurch gekennzeichnet, dass** die Ansteuerschaltung (40) der elektronischen Schaltungsanordnung einen Mikrocontroller aufweist.

9. Schutzschaltung nach einem der Ansprüche 1 bis 8, **dadurch gekennzeichnet, dass** die Stromversorgung der Ansteuerschaltung (4) über den von den nicht abgeschatteten Solarzellen des Solarzellenmoduls (1) erzeugten Strom erfolgt.

10. Schutzschaltung nach einem der Ansprüche 1 bis 9, **dadurch gekennzeichnet, dass** für die Ansteuerschaltung (4) ein Speicherkondensator (8,30) vorgesehen ist.

## Claims

1. Protective circuit for the electrical connection of at least one solar cell of a solar cell module (1), with a protective device having a controlled electronic switching arrangement (3, 100), wherein
the controlled electronic switching arrangement (3, 100) has an actuating circuit (4, 40) and a switching device (5, 10) actuated by the actuating circuit (4, 40), the switching device (5, 10) is hooked up in parallel with at least one solar cell and in event of a shadowing of the solar cell it is at least temporarily actuated by the actuating circuit (4, 40) so that a current bypass is achieved for the shadowed solar cell, **characterized in that** the protective device in the case of the shadowed solar cell acts as a current bypass for the shadowed solar cell in parallel with the shadowed solar cell,
the switching device (5) has two series-switched electrical or electronic switch elements (6, 7) actuated by the actuating circuit (4) and two opposite-poled transistors are provided as switch elements (6, 7).

2. Protective circuit according to claim 1, **characterized in that** the opposite-poled transistors are MOSFETs.

3. Protective circuit for the electrical connection of at least one solar cell of a solar cell module (1), with a protective device having a controlled electronic switching arrangement (3, 100), wherein
the controlled electronic switching arrangement (3, 100) has an actuating circuit (4, 40) and a switching device (5, 10) actuated by the actuating circuit (4, 40) and the switching device (5, 10) is hooked up in parallel with at least one solar cell and in event of a shadowing of the solar cell it is at least temporarily actuated by the actuating circuit (4, 40) so that a current bypass is achieved for the shadowed solar cell, **characterized in that** the protective device in the case of the shadowed solar cell acts as a current bypass for the shadowed solar cell in parallel with the shadowed solar cell, and the protective device has at least one transistor (10) and at least one DC/DC converter (20) hooked up in parallel with it, which is in communication with the actuating circuit (40) across an energy accumulator (30).

4. Protective circuit according to claim 3, **characterized in that** a MOSFET is provided as the transistor (10).

5. Protective circuit according to claim 3 or 4, **characterized in that** several strings (A-X) of solar cells are associated jointly with a protective device, having one parallel switched transistor (10) for each string (A-X), which communicates by its respective gate with an actuating circuit (40).

6. Protective circuit according to claim 5, **characterized in that** the power supply of the actuating circuit (40) comes from a respective DC/DC converter (20) for each string (A-X), the DC/DC converters (20) being switched in parallel with the series circuit of the strings (A-X).

7. Protective circuit according to claim 6, **characterized in that** at least one of the DC/DC converters (20) is associated with an energy accumulator (30).

8. Protective circuit according to one of claims 1 to 7, **characterized in that** the actuating circuit (40) of the electronic switching arrangement has a microcontroller.

9. Protective circuit according to one of claims 1 to 8, **characterized in that** the power supply of the actuating circuit (4) comes from the current generated by the nonshadowed solar cells of the solar cell module (1).

10. Protective circuit according to one of claims 1 to 9, **characterized in that** a storage capacitor (8, 30) is provided for the actuating circuit (4).

## Revendications

1. Circuit de protection pour le raccordement électrique d'au moins une cellule solaire d'un module à cellules solaires (1), comprenant un dispositif de protection qui présente un arrangement de commutation électronique commandé (3, 100), avec lequel
l'arrangement de commutation électronique commandé (3, 100) présente un circuit de commande (4, 40) et un dispositif de commutation (5, 10) pouvant être commandé par le circuit de commande (4, 40), le dispositif de commutation (5, 10) est branché en parallèle avec au moins une cellule solaire et, dans le cas d'un obscurcissement de la cellule solaire, est au moins temporairement déconnecté par le circuit de commande (4, 40) de manière à obtenir une dérivation de courant pour la cellule solaire obscurcie, **caractérisé en ce que** le dispositif de protection, dans le cas de la cellule solaire obscurcie, fait office de dérivation de courant parallèle à la cellule solaire obscurcie pour la cellule solaire obscurcie,
le dispositif de commutation (5) présente deux éléments de commutation (6, 7) électriques ou électroniques branchés en série et commandés par le circuit de commande (4) et les éléments de commutation (6, 7) prévus sont deux transistors à polarités opposées.

2. Circuit de protection selon la revendication 1, **caractérisé en ce que** les transistors à polarités opposées sont des MOSFET.

3. Circuit de protection pour le raccordement électrique d'au moins une cellule solaire d'un module à cellules solaires (1), comprenant un dispositif de protection qui présente un arrangement de commutation électronique commandé (3, 100), avec lequel
l'arrangement de commutation électronique commandé (3, 100) présente un circuit de commande (4, 40) et un dispositif de commutation (5, 10) pouvant être commandé par le circuit de commande (4, 40) et le dispositif de commutation (5, 10) est branché en parallèle avec au moins une cellule solaire et, dans le cas d'un obscurcissement de la cellule solaire, est au moins temporairement déconnecté par le circuit de commande (4, 40) de manière à obtenir une dérivation de courant pour la cellule solaire obscurcie, **caractérisé en ce que** le dispositif de protection, dans le cas de la cellule solaire obscurcie, fait office de dérivation de courant parallèle à la cellule solaire obscurcie pour la cellule solaire obscurcie, et le dispositif de protection présente au moins un transistor (10) et au moins un convertisseur CC/CC (20) branché en parallèle avec celui-ci, lequel est en liaison avec le circuit de commande (40) par le biais d'un accumulateur d'énergie (30).

4. Circuit de protection selon la revendication 3, **caractérisé en ce que** le transistor (10) prévu est un MOSFET.

5. Circuit de protection selon la revendication 3 ou 4, **caractérisé en ce qu'**un dispositif de protection commun est associé à plusieurs chaînes (A - X) de cellules solaires, lequel présente un transistor (10) branché en parallèle avec chaque chaîne (A - X), ledit transistor (10) étant en liaison à chaque fois avec un circuit de commande (40) par le biais de sa gâchette.

6. Circuit de protection selon la revendication 5, **caractérisé en ce que** l'alimentation du circuit de commande (40) de chaque chaîne (A - X) s'effectue par un convertisseur CC/CC (20) correspondant, les convertisseurs CC/CC (20) étant branchés en parallèle avec le circuit série des chaînes (A - X).

7. Circuit de protection selon la revendication 6, **caractérisé en ce qu'**un accumulateur d'énergie (30) est associé à au moins un convertisseur CC/CC (20).

8. Circuit de protection selon l'une des revendications 1 à 7, **caractérisé en ce que** le circuit de commande (40) de l'arrangement de commutation électronique présente un microcontrôleur.

9. Circuit de protection selon l'une des revendications 1 à 8, **caractérisé en ce que** l'alimentation électrique du circuit de commande (4) s'effectue par le biais du courant généré par les cellules solaires non obscurcies du module à cellules solaires (1).

10. Circuit de protection selon l'une des revendications 1 à 9, **caractérisé en ce qu'**un condensateur d'accumulation (8, 30) est prévu pour le circuit de commande (4).
